# EUROPEAN PATENT SPECIFICATION

(11) **EP 1 399 966 B1**
(45) Date of publication and mention of the grant of the patent: **08.12.2004**
(21) Application number: 02744379.5
(22) Date of filing: 17.06.2002
(51) Int. Cl.: H01L 23/58, H01L 23/485

(54) **POWER PADS FOR APPLICATION OF HIGH CURRENT PER BOND PAD IN SILICON TECHNOLOGY**
LEISTUNGSKONTAKTE ZUM AUFSCHLAG HOHER STRÖME PRO ANSCHLUSS IN SILIZIUMTECHNOLOGIE
PLOTS ELECTRIQUES POUR APPLICATION DE HAUTE INTENSITE A TRAVERS UN PLOT DE SOUDURE DANS UNE TECHNOLOGIE DE SILICIUM

(30) Priority: 27.06.2001 US 893160
(43) Date of publication of application: 24.03.2004
(73) Proprietor: Infineon Technologies AG, 81669 München (DE)
(72) Inventor: FRIESE, Gerald, 81669 Munich (DE)
(74) Representative: Kindermann, Peter, Dipl.-Ing.
(86) International application number: PCT/US2002/019095
(87) International publication number: WO 2003/003458

(56) References cited:
- US-A- 5 783 868
- US-A- 6 159 826
- US-B1- 6 239 494

## Description

### BACKGROUND

### 1. Technical Field

This disclosure relates to semiconductor fabrication and more particularly, to structures for semiconductor devices which permit higher current density through bond pads and promote higher long term reliability for bond pads.

### 2. Description of the Related Art

Current flows through conductive structures with minimal resistance. However, due to geometry changes and material changes in the electrical path, higher resistances and higher current densities are experienced. These higher current densities can lead to detrimental mass transport between conductive interfaces at junctions between different conductive materials, as well as in the conductive materials themselves. Further, materials at the conductive interface may cause degradation of conductive characteristics at the interface due to mixing of atoms as a result of mass transport.

Semiconductor devices include many conductive junctions where metals of a first type interface with metals of a second type. Each metal in the design may be selected for a particular reason. For example, copper metallizations are employed due to their high conductivities; however, copper is prone to severe oxidation and quickly degrades in the presence of oxygen. Aluminum, on the other hand, forms an oxide on an outer surface but does not degrade significantly in conductivity. Therefore, in many semiconductor designs copper metallization may include an Aluminum cap to protect the copper from oxidation. One drawback of such an arrangement is the fact that copper and aluminum atoms mix. When aluminum atoms enter a copper matrix significant resistivity increases are experienced. To combat this, a diffusion barrier, which may include Ta or TaN, is deposited between the metals to prevent diffusion therebetween. This diffusion barrier must be as thin as possible to prevent significant increases in resistance to current flow between the metals.

The current capability of bond pads in semiconductor technology employs copper metallization for metal lines. Bond pads are employed for connecting to metal lines of the semiconductor device through pins passing through a chip enclosure, for example. Prior art bond pads employ a same surface for probe contacts used for testing and for wire connections to the bond pad. Damage caused during probe contacts may adversely affect bonding connections formed subsequently. Further, underlying layers below the bond pad may also suffer, for example, damage may be imparted to diffusion barriers between an Aluminum bond pad and an
underlying copper metallization causing detrimental mixing of atoms as described above.

Therefore, a need exists for a structure, which provides a probe pad that permits probe testing without damage to a bond area and underlying metal layers. A further need exists for a structures which permit a bond pad to drive much higher currents per bond pad and is fully integrated in a fine pitch bond pad scheme.
US Patent 5,783,868 explains an extended bond pad that has an area for bonding and an extension area for testing. The extension area is situated at a passivation layer.
From US Patent 6,159,826 a method is known, in which test areas lie in chip scribe lanes. From US Patent 6,239,494 B1 a bond pad is known that consists of aluminium.

### SUMMARY OF THE INVENTION

A structure for a bond pad used on a semiconductor device, in accordance with the present invention includes a metal layer, an interconnect formed through a dielectric layer connecting to the metal layer and a bond pad having a first portion disposed over the metal layer and the interconnect, and a second portion disposed over the dielectric layer. The first portion includes a bond area for providing an attachment point for a connection, and the second portion includes a probe area for providing contact with a probe as recited in claim 1.

In alternate embodiments, the first metal layer may include copper, and the bond pad may include aluminium. The barrier layer is preferably disposed between the interconnect and the metal line to prevent diffusion therebetween. The bond pad may include a thickness of less than about 2 microns. A passivation layer may be formed on the bond pad to protect the bond pad. The passivation layer may include a first opening for the bond area and a second opening for the probe area, the passivation layer may include an opening shared by the bond area and the probe area. The bond pad may be permanently connected to a bond wire. The barrier layer may include Ta or TaN.

These and other objects, features and advantages of the present invention will become apparent from the following detailed description of illustrative embodiments thereof, which is to be read in connection with the accompanying drawings.

### BRIEF DESCRIPTION OF DRAWINGS

This disclosure will present in detail the following description of preferred embodiments with reference to the following figures wherein:
FIG. 1 is a cross-sectional view taken at section line 1-1 of FIG. 4 or FIG. 5 showing a probe area of a bond pad in accordance with the present invention;
FIG. 2 is a cross-sectional view taken at section line 2-2 of FIG. 4 or FIG. 5 showing a bond area of the bond pad in accordance with the present invention;
FIG. 3 is a cross-sectional view taken at section line 3-3 of FIG. 5 showing the bond area and the probe area of the bond pad in accordance with the present invention;
FIG. 4 is a top view of one illustrative embodiment showing the bond area and the probe area of the bond pad in accordance with the present invention;
FIG. 5 is a top view of another illustrative embodiment showing the bond area and the probe area of the bond pad in accordance with the present invention;
FIG. 6 is a cross-sectional view showing a probe contacting a probe area in accordance with the present invention; and
FIG. 7 is a cross-sectional view showing a bonding wire connected to a bond area in accordance with the present invention.

### DETAILED DESCRIPTION OF PREFERRED EMBODIMENTS

The present invention relates to semiconductor fabrication and more particularly, to structures for semiconductor devices, which permit higher current density through bond pads and promote higher long-term reliability for bond pads. The present invention reduces the distance between a bond wire connection and a metal line of a semiconductor device to improve current density capabilities of the structure. In addition, the present invention reduces the possibility of damage due to probing by providing a separate probe area form a bonding area.

The present invention advantageously separates the bond area and the probe area, permits placement of a bond wire on a cap, which is covering the underlying metallization. Therefore, the current per bond pad is no longer limited by the cross section area of the cap, and the probe area is built up by the same cap which, in one example, covers a thick dielectric layer to prevent any damage to the underlying metal.

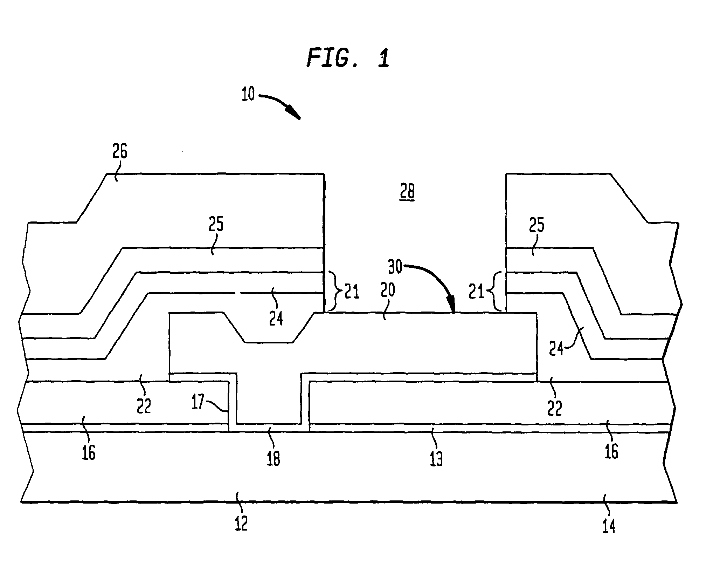

Referring now in specific detail to the drawings in which like reference numerals identify similar or identical elements throughout the several views, and initially to FIG. 1, a cross-sectional view of upper levels of a semiconductor device 10 are shown. Semiconductor device 10 may include a memory chip, such as, a static random access (SRAM) memory chip, a dynamic random access memory (DRAM) chip, an embedded memory chip, etc. Semiconductor device 10 may also include a logic or processor chip, an application specific integrated circuit (ASIC) chip or the like. A metal line 12 is shown for connecting to other metal lines and vias in layers below line 12 (not shown). Line 12 is formed in an interlevel dielectric layer 14. Metal line 12, preferably includes copper, copper alloys or other highly conductive material, such as, for example, Au, Ag or superconductive materials. A nitride layer 13 or other etch stop layer is formed on layer 14 and metal line 12 to protect metal line 12 during the formation of an dielectric layer 16 (also called a terminal via layer or TV layer) such as, for example, an oxide layer. Layer 16 is patterned to form a via or terminal via 17 therethrough. A barrier layer/liner 18 is formed in via 17, and may include Ta, TaN or other diffusion barrier material. A bond pad 20 is formed by depositing a layer of conductive material(s), which protects metal line 12 and is included, for example, on barrier layer 18. Both layers are preferably patterned together. In other embodiments, bond pad 20 may include conductive materials such as for example, copper, copper alloys, Au, Ag or other conductive materials. Bond pad 20 may include a plurality of layers, and preferably includes a cap layer to protect the underlying materials, especially if copper or its alloys are used. The cap layer may include Al, for example.

Next, a passivation layer 21 is formed. Passivation layer 21 may include one or more dielectric layers. In the embodiment shown, an oxide layer 22, a nitride layer 24 and a resist layer 26 are formed and patterned to expose bond pad 20 through opening 28. Resist layer 26 may include a photosensitive polyimide or other resist layer. In one embodiment, multiple layers are employed with resists layer. For example, resist layer 26 may include a polyimide 25 which remains after other portions of layer 26 are removed by etching. Other dielectric layer arrangements are also contemplated. Materials and the number of layers may be varied.

Advantageously, a probe (not shown), employed for testing, contacts bond pad 20 in probe area 30 through opening 28. The conductive path extends through the cross-section and the length of bond pad 20 to reach metal line 12. In the arrangement shown, bond pad 20 is offset from metal line 12. This is advantageous since the barrier layer 18 is so thin that a downward force from a probe could possibly damage barrier layer 18 and permit atomic mixing between conductive materials, such as, aluminum, or other materials, of bond pad 20 and metal line 12, which may include, copper for example. Instead, probe (not shown) contacts bond pad 20 over layer 16 reducing potential damage to diffusion barrier layer 18.

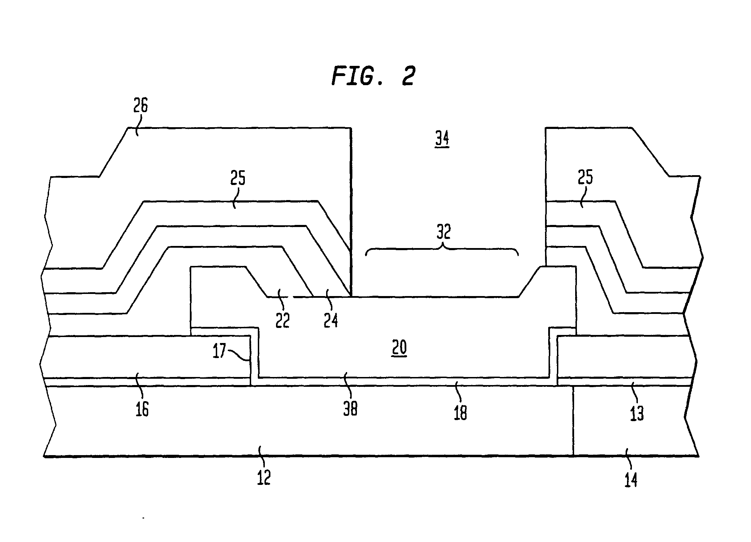

The probe is inserted through hole 28 and is connected to bond pad 20 over TV layer 16 and not over metal line 12. The offset of bond pad 20 also prevents direct damage to metal line during wafer probe testing. Damage to metallization lines can affect current density and reliability of metal lines, and damage to a bond pad can result in difficulty connecting a bond wire thereto or cause reliability problems later on. In accordance with the present invention, damage due to probing is no longer an issue since, the present invention provides an offset area or probe area 30 for probe contact which is separate for a bond area 32 (FIG. 2).

Referring to FIG. 2, bond area 32 is separated from probe area 30 (FIG. 1) and is used for attaching a bond wire through an opening 34. Advantageously, bond area 32 is located directly over metal line 12 and an interconnect 38, thereby reducing resistance between a bond wire (not shown) which connects to bond area 32 and metal line 12.

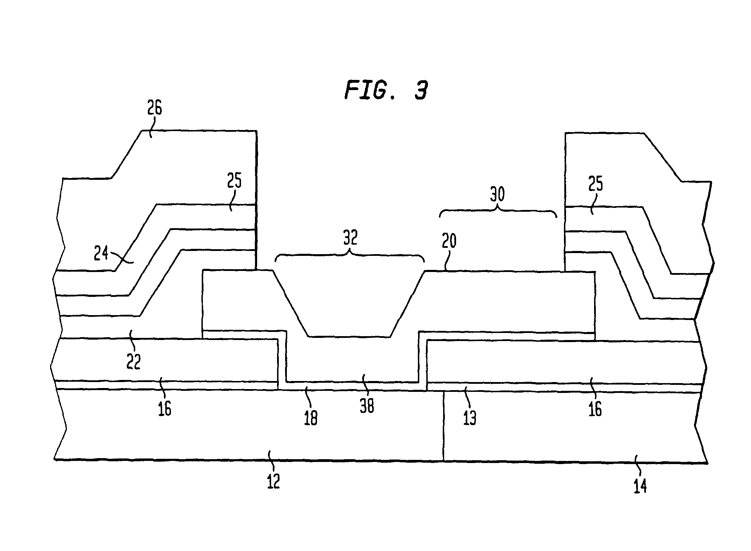

Referring to FIG. 3, to further illustrate the present invention probe area 30 and bond area 32 are shown. Bond area 32 is directly above interconnect 38 while probe area 30 is located over dielectric layer 16. When a probe contacts probe area 30, any damage derived therefrom does not affect bond area 32 since a bonding wire is directly attached to bond area 32. Bond area 32 remains undamaged by probing which results in a better connection with a bonding wire (not shown). Further, barrier layer 18 is preserved since and force imparted to probe area 30 is applied over layer 16.

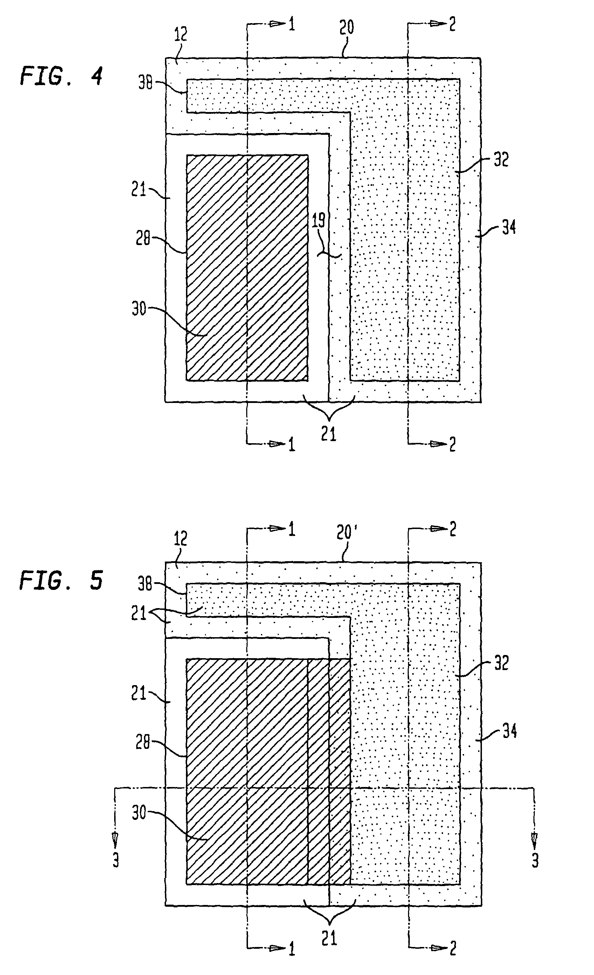

Referring to FIG. 4, a top view of a bond pad 20 is shown in accordance with the present invention. Bond pad 20 includes bond area 32 and probe area 30, which are separate as described above. Passivation layer 21 is patterned to expose bond area 32 and probe area 30. Passivation layer 21 is shown as a transparent layer so that underlying structures are visible. Passivation layer 21 includes layers 22, 24 and possible 25. Passivation layer 21 is patterned to create a border 19 between bond area 32 and probe area 30. Border 19 is preferably employed to prevent slipping of a probe onto the sensitive bond area 32. Border 19 may be formed form other materials as well for example, a raised portion of conductive material from the bond area or the probe area may be employed.

Interconnect 38 is directly below bond area 32 and is shown in the dark gray area. In addition, metal line 12 is directly below interconnect 38 and bond area 32 and is shown in the light gray area. Probe contact may be made in probe area 30. In one embodiment, openings in passivation layer 21 may include one opening 34 for bond area 32 and a second opening 28 for probe area 30. Alternately, one opening (combined openings 28 and 34 of FIG. 5) may be used for both bond area 32 and probe area 30.

One important aspect is the separation of bond area 32 and test area or probe area 30 of bond pad 20. In accordance with the present invention, power pads or bond pads can be fully integrated in the fine pitch bond pad scheme for 0.25 micron or lower groundrule designs. The layout of the power pad or bond pad 20 may be chosen in a way that the vertical extension fits the pattern of conventional bond pads. In this way, processes employed to create bond pad 20 in accordance with the present invention may be similar to the processes used for conventional bond pads. This permits easier integration of the present invention into current process sequences.

Referring to FIG. 5, a top view of an alternate embodiment is shown in accordance with the present invention. In this embodiment, probe area 30 and bond area 32 are continuous. This provides a larger available probing area. Probe area 32 is employed for testing the semiconductor device while bond area 30 is employed for attaching a bond wire to the semiconductor device for providing off-chip connections. It should be noted that probe areas and bond areas are preferably formed as close as possible to interconnect 38 and metal line 12 to reduce electrical resistance for probe testing and ultimately for bond wire connections.

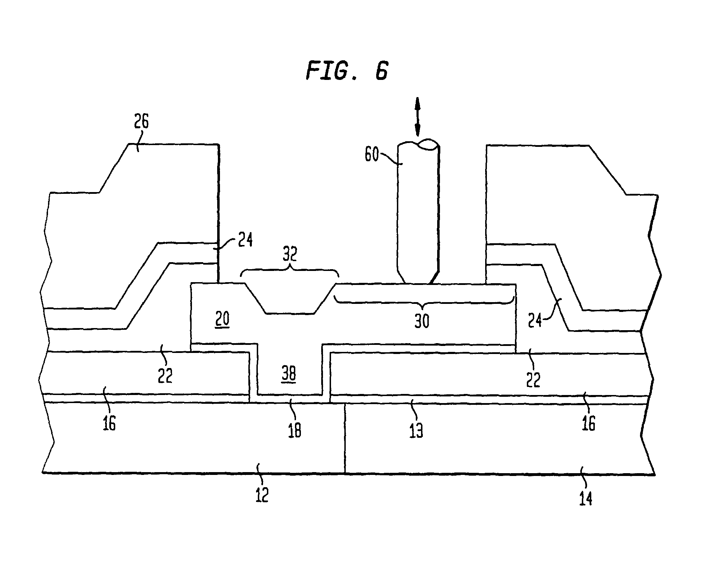

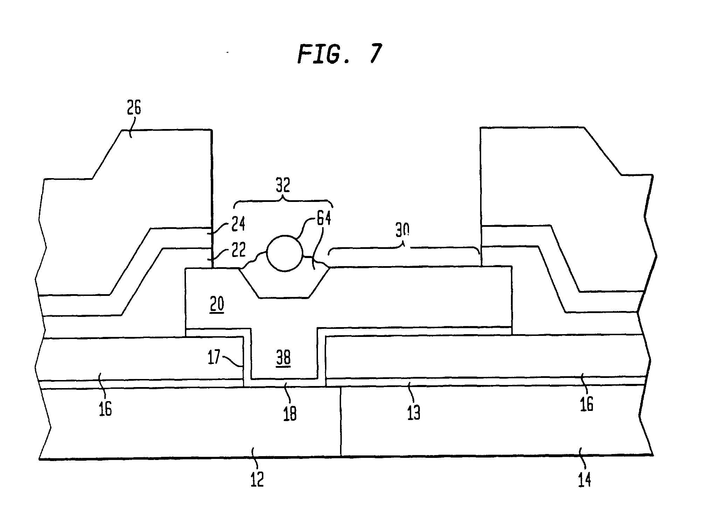

As shown FIG. 6, a probe 60 is illustratively shown making contact to probe area 30. As shown FIG. 7, a bond wire 62 is illustratively shown connected to bond area 32 by solder 64.

It is to be understood that the present invention is particularly useful for incompatible conductive materials or junctions. For example, a copper metal line (e.g., metal line 12) having an Aluminum cap (e.g., bond pad 20) may be employed. It is also to be understood that the use of a thin aluminum cap or other metals in enabled by the present invention. In the prior art, use of a thicker Al cap is typically limited to about 2 microns by capability of the aluminum reactive ion etch tools (the RIE tool over heats for thicker layers), on the other hand, a conventional 2 micron cap is not expected to withstand probing without damage of the metal line (Cu) to diffusion barrier interface. In accordance with the present invention, however, a 2 micron thick or smaller cap layer (bond pad) is sufficient since it will not be damaged in the bond area. Advantageously, the present invention does not need to alter processing significantly.

The present invention also provides for high current power pads. By reducing resistance between metal lines and bonding wires, higher currents are enabled for semiconductor devices. The configurations shown in FIGS. 4 and 5 are illustrative. Other configurations are also contemplated by the present invention.

Surprisingly, an increase in current density, in accordance with the invention, can be several hundreds of percent greater than the prior art bond pads. This may depend in part on the wiring scheme employed. Advantageously, the present invention may adopt a design similar to those currently in use for bond pads for easy process integration and to minimize impact on the design of nearby circuitry.

In one embodiment of the present invention, bond area 32 may include dimensions of about 50 by 120 microns and the probe area 30 may include dimensions of about 50 by 90 microns. Other dimensions are also contemplated.

Having described preferred embodiments for power pads for application of high current per bond pad in silicon technology (which are intended to be illustrative and not limiting), it is noted that modifications and variations can be made by persons skilled in the art in light of the above teachings. It is therefore to be understood that changes may be made in the particular embodiments of the invention disclosed which are within the scope of the invention as outlined by the appended claims.

## Claims

1. A structure (10) for a bond pad used on a semiconductor device comprising:
a metal layer;
an interconnect (38) formed through a dielectric (16) layer connecting to the metal layer;
a bond pad (20) having a first portion (32) disposed over the metal layer and the interconnect (38), and a second portion (30) disposed over the dielectric layer (16);
the first portion (32) including a bond area for providing an attachment point for a connection (64); and
the second portion (30) including a probe area for providing contact with a probe (60),
**characterized in that** the structure (10) has a first cross-section (2-2) through the first portion (32) and through the interconnect (38) but not through the second portion and that the structure (10) has parallel to the first cross-section (2-2) a second cross-section (1-1) through the first portion (32), through the second portion (30) and through the interconnect (38).

2. The structure (10) as recited in claim 1, wherein the metal layer includes copper.

3. The structure (10) as recited in claim 1, wherein the bond pad (20) includes aluminium.

4. The structure (10) as recited in claim 1, further comprising a barrier layer (18) disposed between the interconnect and the metal layer to prevent diffusion there between.

5. The structure (10) as recited in claim 1, wherein the bond pad (20) has a thickness of less than about 2 microns.

6. The structure (10) as recited in claim 1, further comprising a passivation layer (21) formed on the bond pad (20) to protect the bond pad (20).

7. The structure (10) as recited in claim 6, wherein the passivation layer (21) includes a first opening (34) for the bond area (32) and a second opening (28) for the probe area (30).

8. The structure (10) as recited in claim 6, wherein the passivation layer (21) includes an opening shared by the bond area and the probe area.

9. The structure (10) as recited in claim 1, wherein the bond pad (20) is permanently connected to a bond wire (64).

10. The structure (10) as recited in claim 1, wherein
the metal layer is patterned to form at least one metal line (12);
the dielectric layer (18) is formed on the metal layer and patterned to form a via (17) to the at least one metal line (12);
a barrier layer (18) is formed in contact with the metal layer through the via (17); and
the interconnect (38) is formed in the via (17) and connecting to the metal layer through the barrier layer (18).

11. The structure (10) as recited in claim 10, wherein the barrier layer includes Ta or TaN.

12. The structure (10) as recited in claim 1, wherein
a copper layer is patterned to form at least one metal line (12);
the dielectric layer (16) is formed on the copper layer and patterned to form a via (17) to the at least one metal line (12);
a diffusion barrier layer (18) is formed in contact with the copper layer through the via (17);
an aluminium interconnect (38) is formed in the via (17) and connecting to the copper layer through the diffusion barrier layer (18), the diffusion barrier (18) for preventing atomic mixing between the copper layer and the aluminium interconnect (38).

## Patentansprüche

1. Struktur (10) für ein Bondpad, das an einer Halbleitervorrichtung verwendet wird, umfassend:
eine Metallschicht,
eine mit der Metallschicht verbindende Zwischenverbindung (38), die durch eine dielektrische Schicht (16) hindurch ausgebildet ist,
ein Bondpad (20) mit einem ersten Abschnitt (32), der über der Metallschicht und der Zwischenverbindung (38) angeordnet ist, und mit einem zweiten Abschnitt (30), der über der dielektrischen Schicht (16) angeordnet ist,
wobei der erste Abschnitt (32) einen Bondbereich enthält, der einen Befestigungspunkt für eine Verbindung (64) bietet, und
wobei der zweite Abschnitt (30) einen Sondenbereich zum Kontaktieren einer Sonde (60) enthält,
**dadurch gekennzeichnet, dass** die Struktur (10) einen ersten Querschnitt (2-2) durch den ersten Abschnitt (32) und durch die Zwischenverbindung (38), aber nicht durch den zweiten Abschnitt hat, und dass die Struktur (10) parallel zum ersten Querschnitt (2-2) einen zweiten Querschnitt (1-1) durch den ersten Abschnitt (32), durch den zweiten Abschnitt (30) und durch die Zwischenverbindung (38) hat.

2. Struktur (10) nach Anspruch 1, in der die Metallschicht Kupfer enthält.

3. Struktur nach Anspruch 1, in der das Bondpad (20) Aluminium enthält.

4. Struktur (10) nach Anspruch 1, weiter umfassend eine Barriereschicht (18), die zwischen der Zwischenverbindung (38) und der Metallschicht angeordnet ist, um dazwischen eine Diffusion zu verhindern.

5. Struktur (10) nach Anspruch 1, in der das Bondpad (20) eine Dicke von weniger als etwa 2 Mikrometer hat.

6. Struktur (10) nach Anspruch 1, weiter umfassend eine Passivierungsschicht (21), die auf dem Bondpad (20) ausgebildet ist, um das Bondpad (20) zu schützen.

7. Struktur (10) nach Anspruch 6, in der die Passivierungsschicht (21) eine erste Öffnung (34) für den Bondbereich (32) und eine zweite Öffnung (28) für den Sondenbereich (30) enthält.

8. Struktur nach Anspruch 6, in der die Passivierungsschicht (21) eine Öffnung enthält, die sich der Bondbereich und der Sondenbereich teilen.

9. Struktur (10) nach Anspruch 1, in der das Bondpad (20) dauerhaft mit einem Bonddraht (64) verbunden ist.

10. Struktur (10) nach Anspruch 1, in der die Metallschicht so strukturiert ist, dass sie zumindest eine Metallleitung (12) bildet,
die dielektrische Schicht (18) an der Metallschicht ausgebildet und so strukturiert ist, dass sie ein Via (17) zu der zumindest einen Metallleitung (12) bildet,
eine Barriereschicht (18) in Kontakt mit der Metallschicht durch das Via (17) hindurch ausgebildet ist, und
die Zwischenverbindung (38) in dem Via (17) ausgebildet ist, und zur Metallschicht hin durch die Barriereschicht (18) verbindet.

11. Struktur (10) nach Anspruch 10, in der die Barriereschicht Tantal oder Tantalnitrid enthält.

12. Struktur (10) nach Anspruch 1, in der eine Kupferschicht so strukturiert ist, dass sie zumindest eine Metallleitung (12) bildet,
die dielektrische Schicht (16) an der Kupferschicht ausgebildet und so strukturiert ist, dass sie ein Via (17) zu der zumindest einen Metallleitung (12) bildet,
eine Diffusions-Barriereschicht (18) in Kontakt mit der Kupferschicht durch das Via (17) hindurch ausgebildet ist,
eine Aluminium-Zwischenverbindung (38) in dem Via (17) ausgebildet ist und zur Kupferschicht hindurch die Diffusions-Barriereschicht (18) verbindet, wobei die Diffusions-Barriere eine atomare Vermischung zwischen der Kupferschicht und der Aluminium-Zwischenverbindung (38) verhindert.

## Revendications

1. Structure (10) pour un plot de soudure utilisée sur un dispositif à semi-conducteurs comprenant :
une couche métallique ;
une interconnexion (38) formée à travers une couche (16) diélectrique et connectant à la couche métallique ;
un plot (20) de soudure ayant une première partie (32) disposée sur la couche métallique et l'interconnexion (38) et une deuxième partie (30) disposée sur la couche (16) diélectrique ;
la première partie (32) comprenant une zone de soudure pour ménager un point de fixation pour une connexion (64) ; et
la deuxième partie (30) comprenant une zone de sonde pour ménager un contact avec une sonde (60),
**caractérisée en ce que** la structure (10) a une première section transversale (2-2) traversant la première partie (32) et traversant l'interconnexion (38), mais ne traversant pas la deuxième partie et **en ce que** la structure (10) a, parallèlement à la première section transversale (2-2), une deuxième section transversale (1-1) traversant la première partie (32), traversant la deuxième partie (30) et traversant l'interconnexion (38).

2. Structure (10) suivant la revendication 1, dans laquelle la couche métallique comprend du cuivre.

3. Structure (10) suivant la revendication 1, dans laquelle le plot (20) de soudure comprend de l'aluminium.

4. Structure (10) suivant la revendication 1, comprenant en outre une couche (18) formant barrière disposée entre l'interconnexion et la couche métallique pour prévenir une diffusion entre elles.

5. Structure (10) suivant la revendication 1, dans laquelle le plot (20) de soudure a une épaisseur inférieure à environ 2 microns.

6. Structure (10) suivant la revendication 1, comprenant en outre une couche (21) de passivation formée sur le plot (20) de soudure pour protéger le plot (20) de soudure.

7. Structure (10) suivant la revendication 6, dans laquelle la couche (21) de passivation comprend une première ouverture (34) pour la zone (32) de soudure et une deuxième ouverture (28) pour la zone (30) de sonde.

8. Structure (10) suivant la revendication 6, dans laquelle la couche (21) de passivation comprend une ouverture partagée par la zone de soudure et par la zone de sonde.

9. Structure (10) suivant la revendication 1, dans laquelle le plot (20) est connecté en permanence à un fil (64) de liaison.

10. Structure (10) suivant la revendication 1, dans laquelle la couche métallique est structurée pour former au moins une ligne (12) métallique ;
la couche (18) diélectrique est formée sur la couche métallique et est structurée pour former une traversée (17) allant à la au moins une ligne (12) métallique;
une couche (18) formant barrière est formée en contact avec la couche métallique par l'intermédiaire de la traversée (17) ; et
l'interconnexion (38) est formée dans la traversée (17) et est reliée à la couche métallique à travers la couche (18) formant barrière.

11. Structure (10) suivant la revendication 10, dans laquelle la couche formant barrière comprend du Ta ou du TaN.

12. Structure (10) suivant la revendication 1, dans laquelle une couche de cuivre est structurée pour former au moins une ligne (12) métallique ;
la couche (16) diélectrique est formée sur la couche de cuivre et est structurée pour former une traversée (17) allant vers la au moins une ligne (12) métallique ;
une couche (18) formant barrière de diffusion est formée en contact avec la couche de cuivre par l'intermédiaire de la traversée (17) ;
une interconnexion (38) d'aluminium est formée dans la traversée (17) et est reliée à la couche de cuivre à travers la couche (18) formant barrière de diffusion, la couche (18) de diffusion étant destinée à empêcher un mélange d'atomes entre la couche de cuivre et l'interconnexion (38) d'aluminium.
